(19) Europäisches Patentamt
European Patent Office
Office européen des brevets

(11) **EP 3 432 496 A1**

(12) **EUROPEAN PATENT APPLICATION**
published in accordance with Art. 153(4) EPC

(43) Date of publication:
**23.01.2019 Bulletin 2019/04**

(21) Application number: **16894347.0**

(22) Date of filing: **15.03.2016**

(51) Int Cl.:
*H04J 99/00* (2009.01)   *H03M 13/45* (2006.01)
*H04B 7/04* (2017.01)   *H04L 27/38* (2006.01)

(86) International application number:
**PCT/JP2016/058156**

(87) International publication number:
**WO 2017/158725 (21.09.2017 Gazette 2017/38)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **Mitsubishi Electric Corporation
Chiyoda-ku
Tokyo 100-8310 (JP)**

(72) Inventor: **NISHIMOTO, Hiroshi
Tokyo 100-8310 (JP)**

(74) Representative: **Zech, Stefan Markus
Meissner Bolte Patentanwälte
Rechtsanwälte Partnerschaft mbB
Postfach 86 06 24
81633 München (DE)**

(54) **LOG-LIKELIHOOD RATIO CALCULATION CIRCUIT, RECEPTION APPARATUS, AND LOG-LIKELIHOOD RATIO CALCULATION METHOD**

(57)   A LLR calculation unit includes a range detection unit (211) that detects a range in which a received signal resulting from a modulo operation is present among a plurality of ranges defined on the basis of a boundary value in the modulo operation; a coefficient determination unit (212) that determines a coefficient to be used for calculation of a log-likelihood ratio for a most significant bit in quadrature amplitude modulation of the received signal resulting from the modulo operation on the basis of a result of detection by the range detection unit (211); and an LLR computation unit (213) that calculates the log-likelihood ratio for the most significant bit by using the received signal resulting from the modulo operation and the coefficient.

FIG.9

EP 3 432 496 A1

**Description**

Field

The present invention relates to a log-likelihood ratio calculation circuit, a reception device, and a log-likelihood ratio calculation method in a digital communication system.

Background

In digital communication, when an interference signal added to a received signal is known or can be estimated, a nonlinear preprocessing technology called dirty paper coding (DPC) can be applied at the transmission end, so that signal transmission equivalent to a case where no interference signal is present is achieved. The theory of the DPC is disclosed in Non Patent Literature 1.

The DPC theoretically achieves excellent performance, but has a problem in that a process of subtracting an interference signal from a signal to be transmitted is performed at the transmission end and thus the amplitude of the signal to be transmitted obtained by the subtraction is increased. In addition, Non Patent Literatures 2 and 3 disclose a technology for performing waveform shaping by applying a nonlinear operation called a modulo operation to a signal to be transmitted. The DPC in which the operation is applied to a signal to be transmitted obtained by subtraction of interference is called Tomlinson-Harashima precoding (THP).

Typically, a modulo operation is applied to each of a real part and an imaginary part of a complex signal so as to limit the signal within a certain complex region. A boundary value called a modulo boundary value is used to define the certain complex region.

In a case where the THP is performed at the transmitting end, the same modulo operation as the modulo operation applied at the transmitting end is needed at the receiving end so as to correctly detect signal points at the receiving end. For performing soft decision error correction decoding at a reception device, a log-likelihood ratio (LLR) of each bit needs to be obtained. The LLR is also called a soft determination value, a soft input value, or a bit likelihood. An example of a method for calculating an LLR includes, as disclosed in Non Patent Literature 4, calculating the square of the Euclidean distance from a received signal for each of a signal point with the shortest Euclidean distance from the received signal of signal point candidates where a subject bit is 0 (hereinafter, the signal point candidate with the shortest Euclidean distance from a received signal will be referred to as a maximum likelihood signal point) and a maximum likelihood signal point retrieved from signal point candidates where the bit is 1, and calculating the difference between the squares of the Euclidean distance as the LLR. According to theoretical analysis, this method allows mathematical expression depending on the range of a received signal, and an LLR to be uniquely calculated from the value of a received signal as disclosed in Non Patent Literature 5.

Meanwhile, Non Patent Literature 6 discloses, for example, a method for calculating an LLR in a case where a modulo operation is applied, in which a signal point space is extended using a modulo boundary as a repetition reference, signal point candidates before the modulo operation is applied are supposed, and the LLR is obtained for the signal point candidates in the extended signal point space similarly to Non Patent Literature 4. In addition, in Non Patent Literature 7, a mathematical expression for uniquely calculating the LLR of a QAM (quadrature amplitude modulation) modulated signal from the value of a received signal is derived similarly to Non Patent Literature 5 in a case of a specific modulo boundary value.

Citation List

Non Patent Literatures

Non Patent Literature 1: MAX H. M. COSTA, "Writing on Dirty Paper," IEEE TRANSACTIONS ON INFORMATION THEORY, VOL.IT-29, NO.3, pp.439-441, May 1983.
Non Patent Literature 2: M. TOMLINSON, "NEW AUTOMATIC EQUALISER EMPLOYING MODULO ARITHMETIC," ELECTRONICS LETTERS, Vol.7, pp.138-139, March 1971.
Non Patent Literature 3: H. HARASHIMA and H. MIYAKAWA, "Matched-Transmission Technique for Channels With Intersymbol Interference," IEEE TRANSACTIONS ON COMMUNICATIONS, VOL.COM-20, NO.4, pp.774-779, Aug. 1972.
Non Patent Literature 4: H. MATSUOKA, S. Sampei, N. Morinaga, and Y. Kamio, "Adaptive Modulation System with Punctured Convolutional Code for High Quality Personal Communication Systems," IEICE TRANS. COMMUN., VOL.E79-B, NO.3, pp.328-334, March 1996.

Non Patent Literature 5: R. PYNDIAH, A. PICART, A. GLAVIEUX, "PERFORMANCE OF BLOCK TURBO CODED 16-QAM AND 64-QAM MODULATIONS," Proc. Globecom'95, vol.2, pp.1039-1043, Nov. 1995.

Non Patent Literature 6: E.C.Y. Peh and Y.-C. Liang, "Power and Modulo Loss Tradeoff with Expanded Soft Demapper for LDPC Coded GMD-THP MIMO Systems,"IEEE TRANSACTIONS ON WIRELESS COMMUNICATIONS, VOL.8, NO.2, pp.714-724, Feb. 2009.

Non Patent Literature 7: S. Kinjo, "An efficient soft demapper for Tomlinson-Harashima precoded systems," IEICE Communications Express, Vol.4, No.3, pp.89-94, March 2015.

Summary

Technical Problem

The technology disclosed in Non Patent Literature 6, however, can be used for any modulo boundary value but needs to search for a maximum likelihood signal point from signal point candidates resulting from extension based on a modulo boundary, which is disadvantageous in that the amount of computation and the hardware size required for searching are increased as compared to a case in which no modulo operation is performed.

In addition, the technology disclosed in Non Patent Literature 7 enables simple calculation of the LLR of a QAM modulated signal even in a case where a modulo operation is performed, but derives an LLR calculation formula for a specific modulo boundary value $\tau$, which is disadvantageous in that the technology cannot be used for every modulo boundary value. Since an increase in the amplitude of a transmission signal can be more suppressed as the modulo boundary value is smaller, although the communication quality is lower, there has been a demand for a simple LLR calculation method that can be used for any modulo boundary value in order to improve design flexibility of communication devices.

The present invention has been made in view of the above, and an object thereof is to achieve a log-likelihood ratio calculation circuit capable of calculating a log-likelihood ratio associated with any modulo boundary value with a reduced amount of computation and a reduced hardware size in a reception device that performs a modulo operation.

Solution to Problem

To solve the aforementioned problems and achieve the object, a log-likelihood ratio calculation circuit according to the present invention includes a range detection unit that detects a range in which a received signal resulting from a modulo operation is present among a plurality of ranges defined on the basis of a boundary value in the modulo operation; and a coefficient determination unit that determines a coefficient to be used for calculation of a log-likelihood ratio for a most significant bit in quadrature amplitude modulation of the received signal resulting from the modulo operation on the basis of a result of detection by the range detection unit. In addition, the log-likelihood ratio calculation circuit according to the present invention includes a computation unit that calculates the log-likelihood ratio for the most significant bit by using the received signal resulting from the modulo operation and the determined coefficient.

Advantageous Effects of Invention

A log-likelihood ratio calculation circuit according to the present invention produces effects of reducing the amount of computation and the hardware size and allowing calculation of a log-likelihood ratio for any modulo boundary value in a reception device that performs a modulo operation.

Brief Description of Drawings

FIG. 1 is a diagram illustrating an example configuration of a communication system according to a first embodiment.

FIG. 2 is a graph illustrating an example of input/output characteristics of a modulo operation where $\tau$=1.

FIG. 3 is a graph illustrating an example of signal points before a modulo operation in THP.

FIG. 4 is a graph illustrating an example of signal points after the modulo operation in the THP.

FIG. 5 is a diagram illustrating candidates for three-bits signal points associated with an I axis.

FIG. 6 is a table illustrating a multiplication coefficient and an additional value of each subject bit in a case where the modulo operation is not performed.

FIG. 7 is a diagram illustrating an example of signal point candidates before and after a modulo operation in a case where a signal point space is extended.

FIG. 8 is a diagram illustrating an example configuration of an LLR calculation unit according to the first embodiment.

FIG. 9 is a diagram illustrating an example configuration of an LLR calculation unit for $b_0$ according to the first embodiment.

FIG. 10 is a diagram illustrating an example configuration of an LLR calculation unit for $b_1$ according to the first embodiment.

FIG. 11 is a diagram illustrating an example of signal point candidates on an I axis when a modulo operation in 64 QAM modulation is applied.

FIG. 12 is a table illustrating an example of set values set in a range detection unit and a coefficient determination unit of the first embodiment.

FIG. 13 is a diagram illustrating a processing circuit according to the first embodiment.

FIG. 14 is a diagram illustrating an example configuration of a control circuit according to the first embodiment.

Description of Embodiments

A log-likelihood ratio calculation circuit, a reception device, and a log-likelihood ratio calculation method according to an embodiment of the present invention will be described in detail below with reference to the drawings. Note that the present invention is not limited to the embodiment.

First Embodiment.

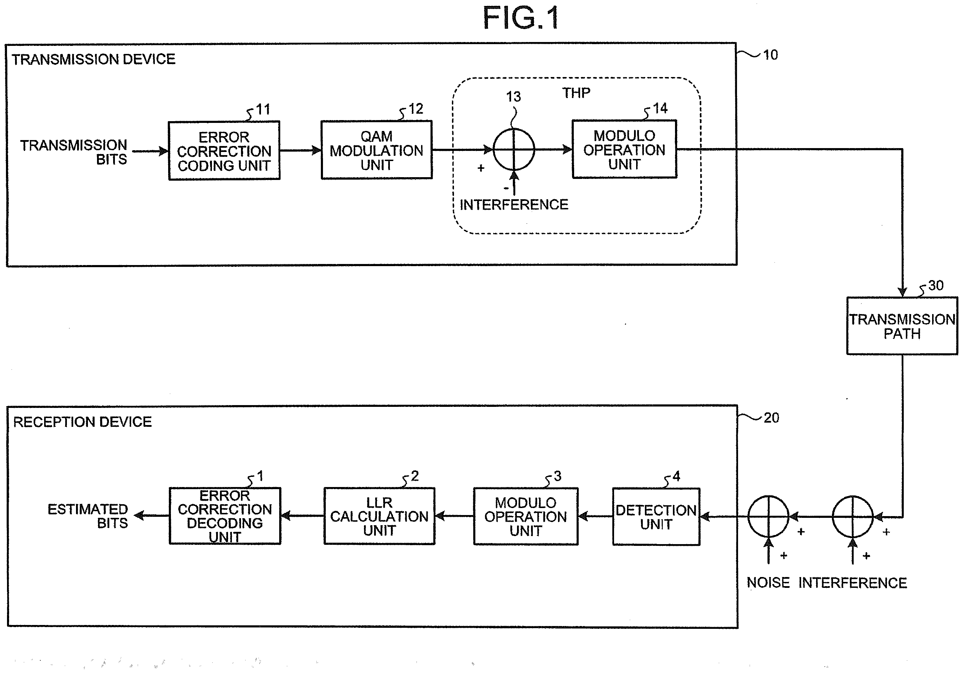

FIG. 1 is a diagram illustrating an example configuration of a communication system according to a first embodiment of the present invention. As illustrated in FIG. 1, the communication system according to the present embodiment includes a transmission device 10 and a reception device 20. A signal transmitted from the transmission device 10 is received by the reception device 20 via a transmission path 30. Typically, interference, that is, an interference signal and noise are added to a signal to be received by the reception device 20 on the transmission path 30.

As illustrated in FIG. 1, the transmission device 10 includes an error correction coding unit 11, a QAM modulation unit 12, an interference subtraction unit 13, and a modulo operation unit 14. The error correction coding unit 11 performs error correction coding on transmission bits, which are information to be transmitted. Any codes may be used as error correction codes, and examples of the codes include convolutional codes, turbo codes, low density parity check (LDPC) codes, and Reed Solomon (RS) codes. In the present embodiment, it is assumed that soft decision decoding is performed in the reception device 20 as will be described later, and error correction codes used in error correction coding are not constrained as long as soft decision can be performed in decoding.

The QAM modulation unit 12 QAM modulates a signal obtained by error correction coding. The interference subtraction unit 13 subtracts an interference signal from a signal obtained by QAM modulation. A process performed by the interference subtraction unit 13 is a process called DPC. In the present embodiment, an interference signal on the transmission path 30 is assumed to be known or capable of being estimated, and the interference subtraction unit 13 removes the known interference signal or the estimated interference signal. In a case where an estimated interference signal is used, any method may be used for estimating an interference signal. In a case of a fixed signal sequence in which an interference signal occurs periodically, for example, an estimation method specifically includes detecting an interference signal by a reception device and informing a transmission device of the interference signal information by using another line from the reception device, so that an interference signal can also be estimated by the transmission device. Alternatively, in a case where a transmission device can cooperate with a transmitting station that is a source of interference, the transmission device can estimate a signal to be interference by being informed of the signal by the transmitting station.

The modulo operation unit 14 performs a modulo operation on a signal obtained by the process by the interference subtraction unit 13. A process performed by the interference subtraction unit 13 and the modulo operation unit 14 is a process called THP. A signal subjected to a modulo operation by the modulo operation unit 14 is transmitted as a transmission signal onto the transmission path 30. A transmission signal may be a radio signal or a signal transmitted by wire.

As illustrated in FIG. 1, the reception device 20 includes a detection unit 4, a modulo operation unit 3, an LLR calculation unit 2, and an error correction decoding unit 1. The detection unit 4 performs a synchronization process and a transmission path fluctuation compensating process as a detection process on a signal received from the transmission device 10 via the transmission path 30. A specific example of the synchronization process includes performing a correlation operation on a received signal sequence and performing timing detection, but any synchronization process may be performed without being limited to the specific example. In addition, a specific example of the transmission path fluctuation compensating process includes estimating a value of a transmission path between a transmitter and a receiver and multiplying a received signal sequence by a complex conjugate of the value to accurately correct a detection axis turned by fluctuation of the transmission path, but any transmission path fluctuation compensating process may be performed without being limited to the specific example. The modulo operation unit 3 performs I/Q separation on a complex signal obtained by the detection process, and performs a modulo operation on a real number signal of each of I and Q. The LLR calculation unit 2, which is a log-likelihood ratio calculation circuit, calculates an LLR by using real number signals obtained by the modulo operations. The error correction decoding unit 1 performs soft decision error correction decoding by using the LLR, and calculates estimated values of transmission bits.

The modulo operation and the THP will now be described. An operator expressed by a formula (1) below is an operator that gives a maximum integer not larger than a. When x represents a signal input to the modulo operation, y represents a signal output from the modulo operation, $\tau$ represents a modulo boundary value, where x and y are real numbers, the modulo operation can be expressed by a formula (2) below. In the formula (2), an input to and an output from the modulo operation are real numbers.

[Formula 1]

$$\lfloor a \rfloor \quad \ldots (1)$$

[Formula 2]

$$y = x - \left\lfloor \frac{x}{2\tau} + \frac{1}{2} \right\rfloor \cdot 2\tau \quad \ldots (2)$$

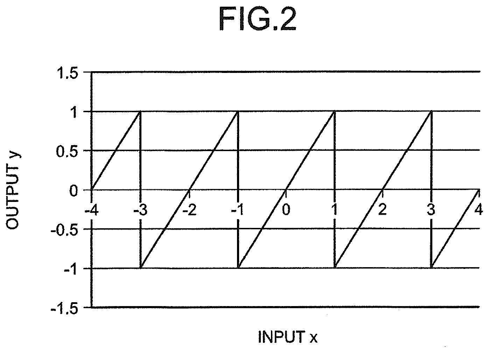

The modulo operation is an operation to limit an input signal within a certain range, and the value that defines the range is a modulo boundary value. A signal obtained by application of the modulo operation is limited to a range of $[-\tau,+\tau]$, and $2\times\tau$ is also called a modulo width. FIG. 2 is a graph illustrating an example of input/output characteristics of the modulo operation where $\tau=1$. When $\tau=1$, the output signal y in response to the input signal x is output as a value with a range limited to [-1,+1], the boundary of the range being $\pm1$.

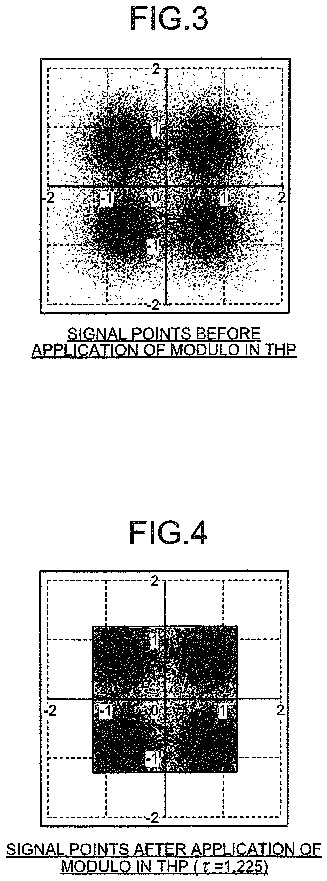

The modulo operation in the THP performed by transmission device 10 is used to limit a signal, which is obtained by removing an interference signal from a complex signal resulting from modulation, within a certain range. FIGS. 3 and 4 are graphs illustrating an example of signal points before and after the modulo operation in the THP. FIG. 3 illustrates an example of signal points in a case where an interference signal is removed from a signal obtained by quadrature phase shift keying (QPSK) modulation. FIG. 4 is a graph illustrating an example of signal points in a case where the modulo operation is applied to the signal illustrated in FIG. 3. Note that, in the examples of FIGS. 3 and 4, an original signal for QPSK is $(\pm1/\sqrt{2}, \pm1/\sqrt{2})$, and the modulo boundary value $\tau$ is 1.225.

Operation in the present embodiment will now be explained. The reception device 20 of the present embodiment receives a signal obtained by the THP performed by the transmission device 10 as described above. While the example of FIGS. 3 and 4 is explained as an example using QPSK modulation for explanation of the modulo operation, the configuration and operation of the present embodiment are also applicable to any Gray-coded M-QAM modulation ($M=2^{2m}$; m is a positive integer) (quadrature amplitude modulation with a level of M). In the description below, 64 QAM modulation (M=64; m=3) is presented as an example.

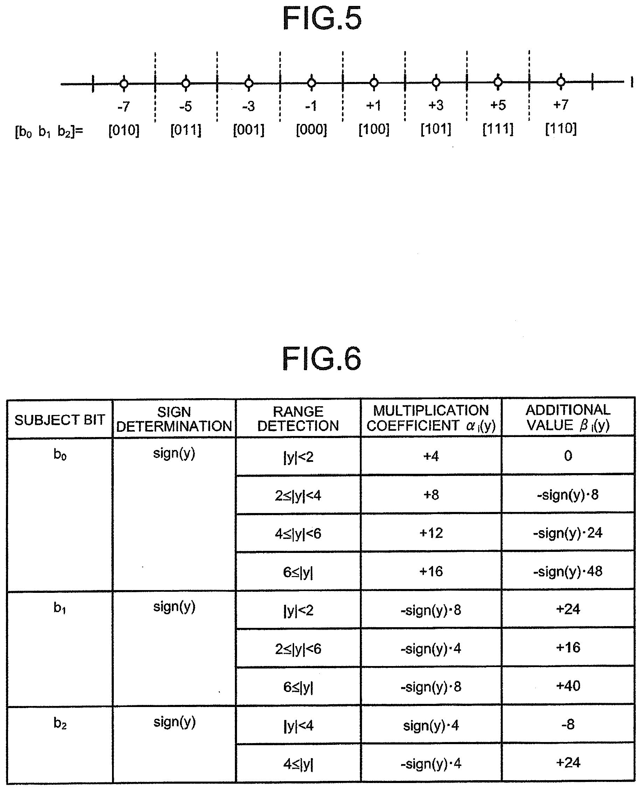

$2^{2m}$-QAM modulation for which 2m bits are mapped to real numbers (I) and imaginary numbers (Q) independently of each other can be separated into m bits on an I axis and m bits on a Q axis for consideration. First, eight points corresponding to three bits $b_0$, $b_1$, and $b_2$ associated with the I axis of the 64 QAM modulated signal will be considered here. FIG. 5 is a diagram illustrating candidates for the three-bit signal points associated with the I axis. As illustrated in FIG. 5, the signal points candidates on the I axis are -2m+1, -2m+3, ..., 2m-3, and $2^m$-1, that is, eight points -7, -5, -3, -1, +1, +3, +5, and +7, and values of three bits $b_0$, $b_1$, and $b_2$ are assigned to each of the points as illustrated in FIG. 6. Specifically, a signal point candidate -7 is assigned to $b_0=0$, $b_1=1$, and $b_2=0$, for example.

The bit $b_0$ of the three bits $b_0$, $b_1$, and $b_2$ is a bit distinguished by positive or negative on the I axis and defined as a most significant bit (MSB). Although the explanation is omitted, the same applies to the Q axis, that is, when three bits associated with the Q axis are represented by $b_3$, $b_4$, and $b_5$, signal points candidates can be defined similarly to the three bits $b_0$, $b_1$, $b_2$ associated with the I axis. The MSB on the Q axis is $b_3$. In addition, in a case where a received signal has such a signal scale that the average power is 1, a received signal is multiplied by $\sqrt{2\times(M-1)/3}$, so that the received signal is corrected to have the same scale as the signal points candidates of -2m+1, -2m+3, ..., 2m-3, and $2^m$-1. In the case of 64 QAM, since m=3, that is, M=64, a received signal is multiplied by $\sqrt{42}$.

The modulo boundary value $\tau$ in the present embodiment, is assumed to be such a value that includes an outermost point of the QAM modulated signal. That is, $2^m-1<\tau$.

In a case where soft decision error correction decoding is performed, the reception device 20 heeds to calculate an LLR. Before explanation of a method for calculating an LLR of the present embodiment, a method for calculating an LLR for a QAM modulated signal in a case where the modulo operation is not applied, that is, a technique disclosed in Non Patent Literatures 4 and 5 will be explained first.

The LLR of a bit $b_i$ (i=0, 1, 2) is defined by a formula (3) below.

[Formula 3]

$$\lambda_{b_i}(y_c) = \frac{1}{2\sigma^2}\left\{ d^2_{b_i=0}(y_c) - d^2_{b_i=1}(y_c) \right\} = \frac{1}{2\sigma^2}\left\{ \min_{s_k \in S_{b_i}=0}\left|y_c - s_k\right|^2 - \min_{s_k \in S_{b_i}=1}\left|y_c - s_k\right|^2 \right\}$$

$$...(3)$$

In the formula (3), $\lambda_{bi}(y_c)$ represents the LLR of the bit $b_i$ when a received complex signal $y_c$ is given, $\sigma 2$ represents noise power, $d_{bi=a}(y)$ represents the Euclidean distance between a maximum likelihood signal point and the signal y where bi=a (a=0, 1), and $S_{bi=a}$ represents a set of signal point candidates where bi=a. Note that, since $1/(2\sigma^2)$ is a fixed coefficient, $\lambda(bar)_{bi}(Y_c)$, which is the LLR without the fixed coefficient, is defined by a formula (4) below. Hereinafter, the LLR will be discussed on the basis of the definitional equation of the formula (4).

[Formula 4]

$$\overline{\lambda}_{b_i}(y_c) = \min_{s_k \in S_{b_i}=0}\left|y_c - s_k\right|^2 - \min_{s_k \in S_{b_i}=1}\left|y_c - s_k\right|^2 \quad ...(4)$$

According to the formula (4), the LLR of the QAM modulated signal is obtained by calculating the square of the Euclidean distance from a received complex signal $y_c$ for each of the maximum likelihood signal point where the subject bit $b_i$ is 0 and the maximum likelihood signal point where the bit $b_i$ is 1, and calculating the difference between the calculated squares. This is the principle of the LLR calculation disclosed in Non Patent Literature 4.

Since the received complex signal $y_c$ has independent I/Q components, the signal $y_c$ is separated into two real number signals of I/Q, and the formula (4) in which a specific maximum likelihood signal point is substituted is solved, which allows the formula (4) to be expressed as a linear formula of a received signal y with classification depending on the range of the received real number signals y with respect to the I axis. For example, theoretical formulae $\lambda(bar)_{b0}(y)(L(y))$, $\lambda(bar)_{b1}(y)$, and $\lambda(bar)_{b2}(y)$ representing the LLRs for three bits $b_0$, $b_1$, and $b_2$ on the I axis of 64 QAM can be expressed by the following formulae (5), (6), and (7), respectively.

[Formula 5]

$$\overline{\lambda}_{b_0}(y) = \begin{cases} 4y & (|y| < 2) \\ 8y - sign(y) \cdot 8 & (2 \le |y| < 4) \\ 12y - sign(y) \cdot 24 & (4 \le |y| < 6) \\ 16 - sign(y) \cdot 48 & (6 \le |y|) \end{cases} \quad ...(5)$$

[Formula 6]

$$\overline{\lambda}_{b_1}(y) = \begin{cases} - sign(y) \cdot 8y + 24 & (|y| < 2) \\ - sign(y) \cdot 4y + 16 & (2 \le |y| < 6) \\ - sign(y) \cdot 8y + 40 & (6 \le |y|) \end{cases} \quad ...(6)$$

[Formula 7]

$$\overline{\lambda}_{b_2}(y) = \begin{cases} sign(y) \cdot 4y - 8 & (|y| < 4) \\ - sign(y) \cdot 4y + 24 & (4 \le |y|) \end{cases} \quad ...(7)$$

Note that sign(y) refers to the sign, that is, a positive or negative sign of the received signal y, and satisfies sign(y)=+1 when y≥0 and sign(y)=-1 when y<0. As is clear from the formulae (5), (6), and (7), the LLR can be calculated by classification depending on the range of the received signal y, determining a multiplication coefficient and an additional value for the corresponding range, and applying the determined multiplication coefficient and additional value to the received signal y. This is the mathematical expression according to the LLR calculation method disclosed in Non Patent Literature 5.

The LLR of a QAM modulated signal can be generalized as a formula (8) below by classification depending on the range of the received signal y according to the formulae (5), (6), and (7). Note that i=0, 1, 2, and $\alpha_i(y)$ and $\beta_i(y)$ represent the multiplication coefficient and the additional value, respectively, for $b_i$.

[Formula 8]

$$\overline{\lambda}_{b_i}(y) = \alpha_i(y) \cdot y + \beta_i(y) \quad \ldots (8)$$

In the formula (8), $\alpha_i(y)$, which is the multiplication coefficient by which the received signal y is multiplied, and $\beta_i(y)$, which is the additional value added to the received signal y are values determined depending on the sign and the range of the received signal y. Thus, the multiplication coefficient $\alpha_i(y)$ and additional value $\beta_i(y)$ of each subject bit can be summarized in a table illustrated in FIG. 6. FIG. 6 is a table illustrating the multiplication coefficient and the additional value of each subject bit in a case where the modulo operation is not performed.

The technique described in Non Patent Literature 5 is, however, disadvantageous in that the LLR of the MSB cannot be obtained correctly by the formula (5) in a case where a modulo operation is applied. In addition, although Non Patent Literature 7 discloses an LLR calculation formula in a case where a modulo operation is applied, Non Patent Literature 7 derives an LLR calculation formula for a specific modulo boundary value $\tau=2^m$, such as $\tau=8$ in the example of the 64 QAM modulated signal points described above, which is disadvantageous in that the LLR calculation formula cannot be used for every modulo boundary value.

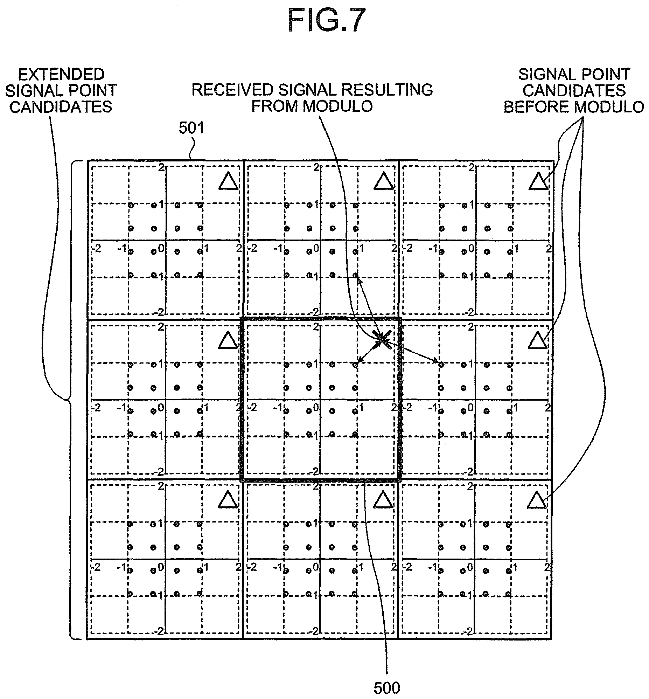

In addition, Non Patent Literature 6 discloses a technique of extending a signal point space using a modulo boundary as a repetition reference. FIG. 7 is a diagram illustrating an example of signal point candidates before and after a modulo operation in a case where a signal point space is extended. In the example of FIG. 7, an image of extended signal point candidates of a 16 QAM modulated signal is illustrated. A range 500 enclosed by a thick line at the center in FIG. 7 indicates a signal point space of a 16 QAM modulated signal before extension, and contains 16 signal points.

A range 501 illustrated in FIG. 7 indicates an extended signal point space, in which 16×9 extended signal point candidates are present. When a modulo operation is performed on signal points indicated by triangles in FIG. 7, a signal point indicated by a cross in FIG. 7 is obtained. According to the method disclosed in Non Patent Literature 6, an LLR is calculated by using signal point candidates in an extended signal point space by the method disclosed in Non Patent Literature 4.

The method disclosed in Non Patent Literature 6 can be used for any modulo boundary value, but needs to search for a maximum likelihood signal point from QAM modulated signal point candidates resulting from extension based on a modulo boundary. This is disadvantageous in that the amount of computation and the hardware size required for searching are increased as compared to a case in which no modulo operation is performed.

In view of the above, in the present embodiment, a configuration and operation of the LLR calculation unit 2 capable of reducing the amount of computation and the hardware size of the reception device 20 and using a modulo boundary value even in a case where the transmission device 10 performs the THP will be described.

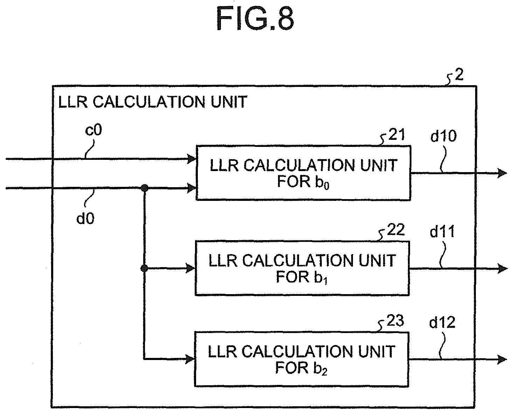

FIG. 8 is a diagram illustrating an example configuration of the LLR calculation unit 2 in the present embodiment. As illustrated in FIG. 8, the LLR calculation unit 2 of the present embodiments includes an LLR calculation unit 21 for $b_0$, an LLR calculation unit 22 for $b_1$, and an LLR calculation unit 23 for $b_2$.

A signal c0 indicating a modulo boundary value $\tau$ from the modulo operation unit 3 provided before the LLR calculation unit 2 and a real number signal on either of the I axis or the Q axis resulting from the detection process and the modulo operation performed on a received complex signal are input to the LLR calculation unit 2. Herein, the signal on the I axis or the real number signal on the Q axis subjected to the LLR calculation is represented by d0. Output signals output from the LLR calculation unit 2 are d10, which is an LLR for $b_0$ output from the LLR calculation unit 21 for $b_0$, d11, which is an LLR for $b_1$ output from the LLR calculation unit 22 for $b_1$, and d12, which is an LLR for $b_2$ output from the LLR calculation unit 23 for $b_2$. The modulo boundary value c0 is input to the LLR calculation unit 21 for $b_0$.

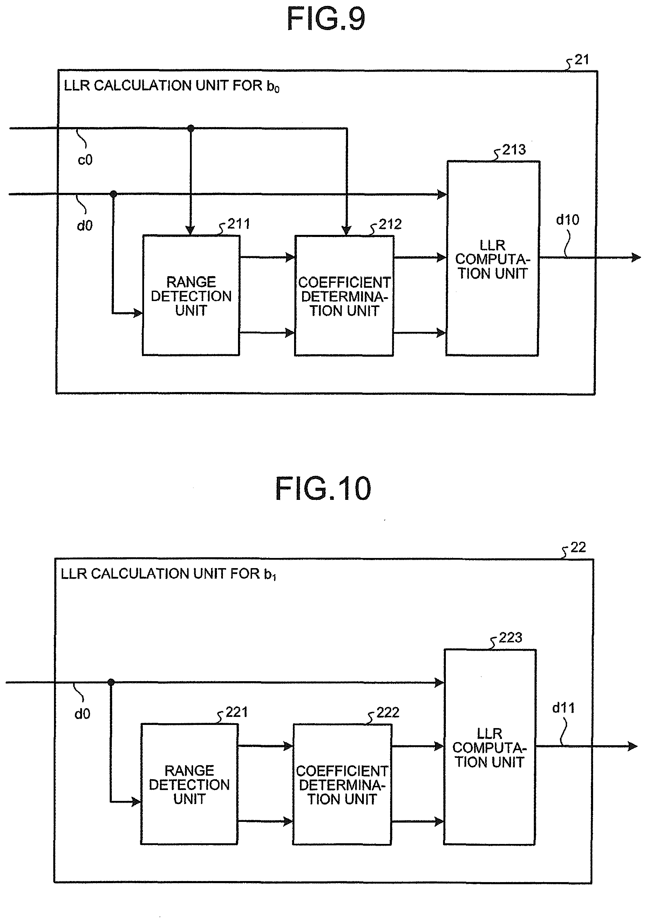

FIG. 9 is a diagram illustrating an example configuration of the LLR calculation unit 21 for $b_0$. The LLR calculation unit 21 for $b_0$ includes a range detection unit 211, a coefficient determination unit 212, and an LLR computation unit 213.

The range detection unit 211 performs positive/negative determination and detection of the range of an absolute value on the input d0. Specifically, the range detection unit 211 detects a range in which a received signal resulting from the modulo operation is present among a plurality of ranges defined on the basis of a boundary value in the modulo operation. More specifically, the range detection unit 211 determines whether or not d0 is equal to or larger than 0, and determines a range in which the absolute value of d0 is present among a plurality of ranges associated with $b_0$, which will be described later. Note that the ranges associated with $b_0$ are determined depending on c0, that is, $\tau$. The result of determination on the range in which the absolute value of d0 is present among a plurality of ranges will be hereinafter referred to as a detected range value. d0 corresponds to the received signal y, and c0 corresponds to the aforementioned $\tau$. Thus, the range detection unit 211 obtains sign(y) and the detected range value. The range detection unit 211 outputs the obtained sign(y) and detected range value to the coefficient determination unit 212.

The coefficient determination unit 212 obtains a multiplication coefficient $\alpha_0(y)$ and an additional value $\beta_0(y)$ on the basis of sign(y) and the detected range value received from the range detection unit 211 and c0, that is, $\tau$ input from the modulo operation unit 3, and outputs the obtained multiplication coefficient $\alpha_0(y)$ and additional value $\beta_0(y)$ to the LLR computation unit 213. The multiplication coefficient $\alpha_0(y)$ and the additional value $\beta_0(y)$ are coefficients for calculation of the LLR. Coefficients mentioned herein include the multiplication coefficient $\alpha_0(y)$, and a constant term, that is, the additional value $\beta_0(y)$. Specifically, the coefficient determination unit 212 determines the coefficients to be used for calculation of the LLR of the most significant bit in quadrature amplitude modulation of the received signal resulting from the modulo operation on the basis of the result of detection by the range detection unit 211.

The LLR computation unit 213 calculates the LLR according to the aforementioned formula (8) by using the multiplication coefficient $\alpha_0(y)$ and the additional value $\beta_0(y)$ received from the coefficient determination unit 212 and d0 received from the modulo operation unit 3, and outputs the LLR for the bit $b_0$ as d10 to the subsequent error correction decoding unit 1. In other words, the LLR computation unit 213 is a computation unit that computes the log-likelihood ratio of the most significant bit by using the received signal resulting from the modulo operation and the coefficients determined by the coefficient determination unit 212. Specifically, the LLR computation unit 213 computes the LLR of the most significant bit by multiplying the received signal resulting from the modulo operation by the multiplication coefficient $\alpha_0(y)$ and adding the additional value $\beta_0(y)$ to the result of the multiplication.

FIG. 10 is a diagram illustrating an example configuration of the LLR calculation unit 22 for $b_1$. As illustrated in FIG. 10, the configuration of the LLR calculation unit 22 for $b_1$ is the same as the configuration of the LLR calculation unit 21 for $b_0$ except that the modulo boundary value c0 is not input.

The LLR calculation unit 22 for $b_1$ includes a range detection unit 221, a coefficient determination unit 222, and an LLR computation unit 223. The range detection unit 221 performs positive/negative sign determination and range detection on d0 input from the modulo operation unit 3. In the range detection by the range detection unit 221, a range in which the absolute value of d0 is present is determined among a plurality of predetermined ranges associated with $b_1$.

The range detection unit 221 outputs the obtained detected range value to the coefficient determination unit 222. The coefficient determination unit 222 obtains a multiplication coefficient $\alpha_1(y)$ and an additional value $\beta_1(y)$ on the basis of sign(y) and the detected range value received from the range detection unit 221, and outputs the obtained multiplication coefficient $\alpha_1(y)$ and additional value $\beta_1(y)$ to the LLR computation unit 223.

The LLR computation unit 223 calculates the LLR according to the aforementioned formula (8) by using the multiplication coefficient $\alpha_1(y)$ and the additional value $\beta_1(y)$ received from the coefficient determination unit 222 and d0 received from the modulo operation unit 3, and outputs the LLR for the bit $b_1$ as d11 to the subsequent error correction decoding unit 1.

Since the configuration of the LLR calculation unit 23 for $b_2$ is similar to the configuration of the LLR calculation unit 22 for $b_1$, illustration and description thereof will not be provided. A range detection unit of the LLR calculation unit 23 for $b_2$ performs positive/negative sign determination and range detection on d0 input from the modulo operation unit 3. In the range detection by the LLR calculation unit 23 for $b_2$, a range in which the absolute value of d0 is present is determined among a plurality of predetermined ranges associated with $b_2$.

The range detection unit of the LLR calculation unit 23 for $b_2$ outputs the obtained detected range value to a coefficient determination unit of the LLR calculation unit 23 for $b_2$. The coefficient determination unit of the LLR calculation unit 23 for $b_2$ obtains a multiplication coefficient $\alpha_2(y)$ and an additional value $\beta_2(y)$ on the basis of sign(y) and the detected range value received from the range detection unit, and outputs the obtained multiplication coefficient $\alpha_2(y)$ and additional value $\beta_2(y)$ to the LLR computation unit.

The LLR computation unit calculates the LLR according to the aforementioned formula (8) by using the multiplication coefficient $\alpha_2(y)$ and the additional value $\beta_2(y)$ received from the coefficient determination unit and d0 received from the modulo operation unit 3, and outputs the LLR for the bit $b_1$ as d12 to the subsequent error correction decoding unit 1.

Next, the principle of specific operations of the range detection units and the coefficient determination units in the present embodiment will be explained.

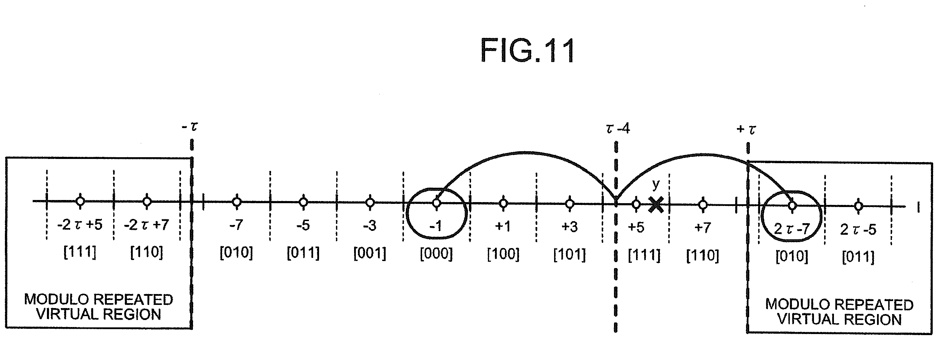

FIG. 11 is a diagram illustrating an example of signal point candidates on the I axis when a modulo operation in 64 QAM modulation is applied. As described above, assume that $\tau > 2^m-1=7$ is satisfied here. The region of the received signal y is limited to $|y| < \tau$ by the modulo operation. When a signal point before the modulo operation is represented by x, x can also be a value in a region where $|x| \geq \tau$ is satisfied. Assume here that eight points - $2\tau+1$, $-2\tau+3$, $-2\tau+5$, $-2\tau+7$,

$2\tau$-7, $2\tau$-5, $2\tau$-3, and $2\tau$-1 are added as supposed signal point candidates before the modulo operation, and that the maximum likelihood signal point is retrieved from a total of 16 points. This is a principle model of the technology disclosed in Non Patent Literature 6, and the added signal point region, that is, the region where $|x|\geq\tau$ is satisfied will be referred to as a modulo repeated virtual region.

Signal points $-2\tau$+1, $-2\tau$+3, $-2\tau$+5, and $-2\tau$+7 among the signal points in the modulo repeated virtual region correspond to original signal points +1, +3, +5, and +7, respectively. Note that original signal points are signal points before the signal points in the modulo repeated virtual region are added. The same bits as those of the corresponding original signal points +1, +3, +5, and +7 are assigned to the signal points $-2\tau$+1, $-2\tau$+3, $-2\tau$+5, and $-2\tau$+7, respectively, and the MSB of these signal points is $b_0$=1. Similarly, signal points $2\tau$-7, $2\tau$-5, $2\tau$-3, and $2\tau$-1 correspond to original signal points -7, -5, -3, -1, respectively, and the MSB of these signal points is bo=0.

The LLR of the MSB is classified by the range of the possible value of y including the modulo repeated virtual region on the basis of the aforementioned formula (4). While a case of $y\geq0$ is described herein, the description is similarly applicable to the case of y<0.

When $y\geq0$, the maximum likelihood signal point of $b_0$=1 is a signal point with the shortest Euclidean distance from, that is, being the shortest to the received signal resulting from the modulo operation, which is uniquely determined. Specifically, when n=0, 1, 2, the maximum likelihood signal point of $b_0$=1 is 2n+1 when y is within a range satisfying $2n\leq y<2(n+1)$, and the maximum likelihood signal point of $b_0$=1 is the signal point +7, which is the outermost of the original signal points, when y is within a range satisfying $6\leq y$. For example, in a case where y is equal to or larger than 2 but smaller than 4, $2n\leq y<2(n+1)$ is satisfied when n=1 and the maximum likelihood signal point of $b_0$=1 is +3.

The maximum likelihood signal point of $b_0$=0, which is an inverted bit of $b_0$=1, also varies depending on the range of the possible value of y, and the maximum likelihood signal point is either of -1 or $2\tau$-7 among the signal point candidates. Specifically, $\tau$-4, which is the center of -1 and $2\tau$-7, is a boundary of the ranges, and the maximum likelihood signal point of $b_0$=0 when y<$\tau$-4 is -1 while the maximum likelihood signal point of $b_0$=0 when $\tau$-4$\leq$y is $2\tau$-7. Note that the former case (the maximum likelihood signal point of $b_0$=0 when y<$\tau$-4) is equal to the maximum likelihood signal point in the case where no modulo operation is applied.

In light of the above, the maximum likelihood signal point of $b_0$=1 is classified into the following conditions (a) and (b):

condition (a): $2n\leq y<2(n+1)$ ; (n=0, 1, 2); and
condition (b): $6\leq y$.

The maximum likelihood signal point of $b_0$=0 is classified into the following conditions (c) and (d):

condition (c): y<$\tau$-4; and
condition (d): $\tau$-4$\leq$y.

$2\times2$=4 combinations of the two conditions for $b_0$=1, which are the condition (a) and the condition (b), and the two conditions for $b_0$=0, which are the condition (c) and the condition (d), described above are present. A specific LLR calculation formula for each of the four combinations will be provided below.

Under the condition (a) and the condition (c), the LLR of $b_0$ that is the MSB is obtained as in the following formula (9) on the basis of the formula (4).
[Formula 9]

$$\overline{\lambda}_{b_0}(y) = \left| y - (-1) \right|^2 - \left| y - (2n+1) \right|^2$$
$$= y^2 + 2y + 1 - \left\{ y^2 - 2(2n+1)y + (2n+1)^2 \right\}$$
$$= 4(n+1)y - 4(n+1)n \qquad \dots (9)$$

Under the condition (b) and the condition (c), the LLR of $b_0$ that is the MSB is obtained as in the following formula (10) on the basis of the formula (4).
[Formula 10]

$$\overline{\lambda}_{b_0}(y) = \left|y - (-1)\right|^2 - \left|y - (+7)\right|^2$$
$$= y^2 + 2y + 1 - \left\{y^2 - 14y + 49\right\}$$
$$= 16y - 48 \qquad \dots(10)$$

Under the condition (a) and the condition (d), the LLR of $b_0$ that is the MSB is obtained as in the following formula (11) on the basis of the formula (4). In this case, however, the integer n that satisfies $2\times n\le y<2\times(n+1)$ is equal to or larger than the maximum integer not exceeding $(\tau-4)/2$ according to $\tau>7$ and the condition (d).
[Formula 11]

$$\overline{\lambda}_{b_0}(y) = \left|y - (2\tau - 7)\right|^2 - \left|y - (2n + 1)\right|^2$$
$$= y^2 - 2(2\tau - 7)y + (2\tau - 7)^2 - \left\{y^2 - 2(2n + 1)y + (2n + 1)^2\right\}$$
$$= 4(-\tau + n + 4)y - 4(-\tau + n + 4)(\tau + n - 3)$$
$$\dots(11)$$

Under the condition (b) and the condition (d), the LLR of $b_0$ that is the MSB is obtained as in the following formula (12) on the basis of the formula (4).
[Formula 12]

$$\overline{\lambda}_{b_0}(y) = \left|y - (2\tau - 7)\right|^2 - \left|y - (+7)\right|^2$$
$$= 4(-\tau + 7)y - 4\tau(-\tau + 7) \qquad \dots(12)$$

While the formulae (9) to (12) described above are calculation formulae in the case of $y\ge0$, specific LLR calculation formulae in the case of $y<0$ can be derived through similar classification. Detailed description of the process for deriving the formulae is omitted; however, the LLR of $b_0$ in the cases of $y\ge0$ and $y<0$ can be summarized as in the following formula (13).
[Formula 13]

$$\overline{\lambda}_{b_0}(y)=\begin{cases} 4(n+1)y-\mathrm{sign}(y)\cdot4(n+1)n & \left(|y|<\tau-4 \ and \ 2n\le|y|<2(n+1), n=0,1,2\right) \\ 16y-\mathrm{sign}(y)\cdot48 & \left(|y|<\tau-4 \ and \ 6\le|y|\right) \\ 4(-\tau+n+4)y-\mathrm{sign}(y)\cdot4(-\tau+n+4)(\tau+n-3) & \left(\tau-4\le|y| \ and \ 2n\le|y|<2(n+1), n=\left\lfloor\frac{\tau-4}{2}\right\rfloor,\cdots,2\right) \\ 4(-\tau+7)y-\mathrm{sign}(y)\cdot4\tau(-\tau+7) & \left(\tau-4\le|y| \ and \ 6\le|y|\right) \end{cases}$$
$$\dots(13)$$

While the example of 64 QAM is presented in the description above, the method for calculating the LLR of $b_0$ that is the MSB in a case where a modulo operation is applied can be generalized for any Gray-coded $2^{2m}$-QAM modulation (m is a positive integer equal to or larger than 1) as expressed by a formula (14) below. Note that the method is the same as that for QPSK modulation when m=1.
[Formula 14]

$$\overline{\lambda}_{b_0}(y)=\begin{cases} 4(n+1)y-\mathrm{sign}(y)\cdot4(n+1)n & \left(|y|<\tau-2^{m-1} \ and \ 2n\le|y|<2(n+1), n=0,\cdots,2^{m-1}-2\right) \\ 2^{m+1}y-\mathrm{sign}(y)\cdot2^{m+1}(2^{m-1}-1) & \left(|y|<\tau-2^{m-1} \ and \ 2^m-2\le|y|\right) \\ 4(-\tau+n+2^{m-1})y-\mathrm{sign}(y)\cdot4(-\tau+n+2^{m-1})(\tau+n-2^{m-1}+1) & \left(\tau-2^{m-1}\le|y| \ and \ 2n\le|y|<2(n+1), n=\left\lfloor\frac{\tau-2^{m-1}}{2}\right\rfloor,\cdots,2^{m-1}-2\right) \\ 4(-\tau+2^m-1)y-\mathrm{sign}(y)\cdot4\tau(-\tau+2^m-1) & \left(\tau-2^{m-1}\le|y| \ and \ 2^m-2\le|y|\right) \end{cases}$$
$$\dots(14)$$

For bits other than the MSB, the method is the same as that in the case where no modulo operation is applied, that is, the case where no signal points in a modulo repeated virtual region are added. For example, the LLRs of $b_1$ and $b_2$ in the case of 64 QAM can be calculated by the formulae (6) and (7). This is because no signal point candidates in a modulo repeated virtual region will be the maximum likelihood signal point for bits other than the MSB in the case of Gray-coded QAM modulated signal points.

In the present embodiment, specific processes performed by the range detection unit 211 and the coefficient determination unit 212 of the LLR calculation unit 21 for $b_0$ are set on the basis of the principle described above. Specifically, the range detection unit 211 calculates sign(y), and performs range detection according to the four conditions classified in the formula (14). The coefficient determination unit 212 calculates the multiplication coefficient $\alpha_0(y)$ and the additional value $\beta_0(y)$ according to the formula (14) on the basis of sign(y) and the result of range detection.

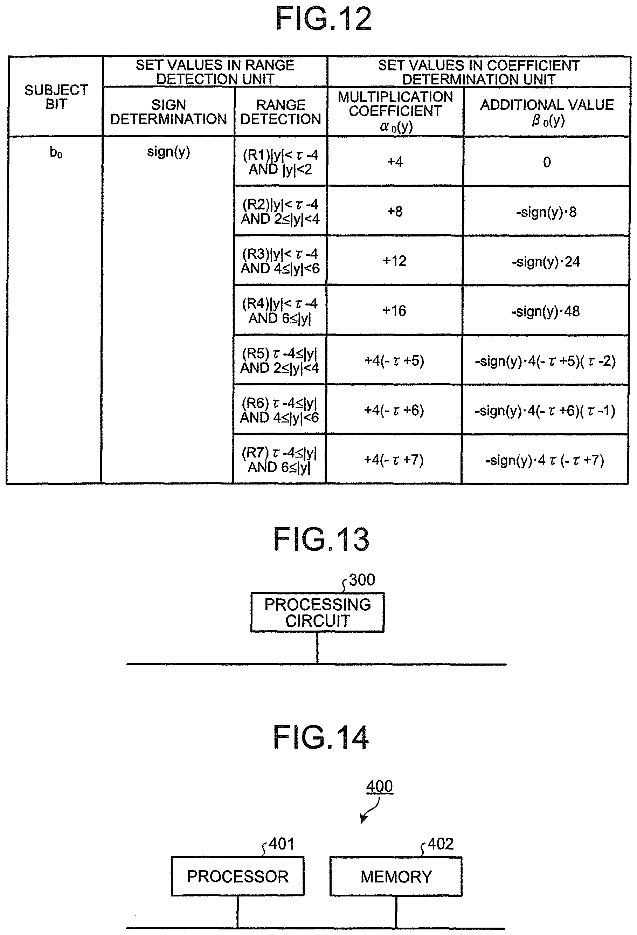

Specifically, for example, in a case where a 64 QAM modulated signal is used, the range detection unit 211 and the coefficient determination unit 212 are set in advance as described below. FIG. 12 is a table illustrating an example of set values set in the range detection unit 211 and the coefficient determination unit 212 of the present embodiment. As illustrated in FIG. 12, a table or a calculation formula for determining seven ranges (RI) to (R7) is set in the range detection unit 211. In addition, as illustrated in FIG. 12, associations between results of the determination of the range detection unit 211 and a table or a calculation formula for calculating the multiplication coefficient and the additional value are set in the coefficient determination unit 212. As a result, when y is determined to be within the range R1 by the range detection unit 211, for example, the coefficient determination unit 212 determines $\alpha_0(y)$ and $\beta_0(y)$ as $\alpha_0(y)=+4$ and $\beta_0(y)=0$, respectively, as illustrated in FIG. 12. The LLR computation unit 213 calculates the LLR of $b_0$ according to the formula (8) described above by using the multiplication coefficient $\alpha_0(y)$ and the additional value $\beta_0(y)$, and d0, that is, y received from the modulo operation unit 3 as described above.

In the LLR calculation unit 22 for $b_1$ and LLR calculation unit 23 for $b_2$, the range detection units and the coefficient setting units are set according to subject bits corresponding to those in FIG. 6. Specifically, a table or a calculation formula for determining the three ranges presented in FIG. 6 is set in the range detection unit of the LLR calculation unit 22 for $b_1$. Associations between results of the range detection unit of the LLR calculation unit 22 for $b_1$ and a table or a calculation formula for calculating the multiplication coefficient and the additional value for $b_1$ are set in the coefficient setting unit of the LLR calculation unit 22 for $b_1$. In addition, a table or a calculation formula for determining the two ranges presented in FIG. 6 is set in the range detection unit of the LLR calculation unit 23 for $b_2$. Associations between results of the range detection unit of the LLR calculation unit 23 for $b_2$ and a table or a calculation formula for calculating the multiplication coefficient and the additional value for $b_2$ are set in the coefficient setting unit of the LLR calculation unit 23 for $b_2$.

Next, a hardware configuration of the reception device 20 of the present embodiment will be described. Each of the components included in the reception device 20 illustrate in FIG. 1 can be implemented by an electronic circuit. The detection unit 4 is an equalizer or a demodulator. In a case where a modulation process includes a discrete Fourier transform process, a discrete Fourier transform processing circuit is added to the detection unit 4. The modulo operation unit 3 is a processing circuit that performs a modulo operation, and the LLR calculation unit 2 is a processing circuit that calculates an LLR as described above. The error correction decoding unit 1 is a processing circuit that performs error correction decoding, and additionally includes a deinterleaver in a case where bit interleaving is performed at the transmission device 10.

The processing circuit for implementing the LLR calculation unit 2 may be dedicated hardware or may be a control circuit including a memory and a central processing unit (CPU; also referred to as a central processor, a processing unit, a computing unit, a microprocessor, a microcomputer, a processor, or a digital signal processor (DSP)) that executes programs stored in the memory. Note that the memory may be nonvolatile or volatile semiconductor memory such as a random access memory (RAM), a read only memory (ROM), a flash memory, an erasable programmable read only memory (EPROM), or an electrically erasable programmable read only memory (EEPROM), a magnetic disk, a flexible disk, an optical disk, a compact disc, a mini disc, a digital versatile disc (DVD) or the like, for example.

In a case where the LLR calculation unit 2 is implemented by dedicated hardware, the hardware is a single circuit, a composite circuit, a programmed processor, a parallel-programmed processor, an application specific integrated circuit (ASIC), a field-programmable gate array (FPGA), or combination thereof, for example. In a case where a processing circuit is implemented by dedicated hardware, the processing circuit is a processing circuit 300 illustrated in FIG. 13, for example. FIG. 13 is a diagram illustrating the processing circuit 300.

In a case where the LLR calculation unit 2 is implemented by a control circuit including a CPU, the control circuit is a control circuit 400 having a configuration illustrated in FIG. 14, for example. As illustrated in FIG. 14, the control circuit 400 includes a processor 401, which is a CPU, and a memory 402. FIG. 14 is a diagram illustrating an example configuration of the control circuit 400. In a case where the LLR calculation unit 2 is implemented by the control circuit 400 illustrated in FIG. 14, the processor 401 is implemented by reading and execution of a program corresponding to the process of the LLR calculation unit 2 stored in the memory 402. The memory 402 is also used as a temporary memory in the processes performed by the processor 401.

In addition, at least part of the detection unit 4, the modulo operation unit 3, and the error correction decoding unit 1 may be implemented by the processing circuit 300, which is dedicated hardware, or may be implemented by the control circuit 400, similarly to the LLR calculation unit 2 described above.

Similarly, each of the components included in the transmission device 10 illustrated in FIG. 1 can be implemented by an electronic circuit. The error correction coding unit 11, the QAM modulation unit 12, the interference subtraction unit 13, and the modulo operation unit 14 in the transmission device 10 may each be implemented by a processing circuit 300, which is dedicated hardware, or may each be implemented by a control circuit 400.

As described above, in the reception device 20 of the present embodiment, an LLR for $b_0$ that is the MSB can be simply calculated for any modulo boundary value by the range detection unit 211, the coefficient determination unit 212, and the LLR computation unit 213 described above. Regarding the LLR calculation units 22 and 23 for bits $b_1$ and $b_2$, detailed description of specific operation will not be provided since the LLR calculation need not use the modulo boundary value as described above and is thus the same as the LLR calculation in QAM modulation where no modulo operation is used.

While the example of 64 QAM is presented in the description of the present embodiment, the present embodiment is also applicable to respective MSBs of I and Q in any Gray-coded $2^{2m}$-QAM modulation (m is an integer equal to or larger than 1) as expressed by the formula (14).

In addition, while multiplication of a coefficient $1/(2\sigma 2)$ for reflecting noise power defined by the formula (2) is not included in the processes performed by the LLR computation unit 213 explained in the present embodiment, the multiplication of the coefficient $1/(2\sigma 2)$ may be included in the processes performed by the LLR computation unit 213. For example, in a case where a plurality of LLRs having different noise powers are processed at the same time by the subsequent error correction decoding unit 1 and where $\sigma 2$ is known or can be estimated, the LLR computation unit 213 may multiply the calculated values of the LLRs by the coefficient $1/(2\sigma 2)$. Alternatively, in a case where the signal-to-noise power ratio (SNR) varies among a plurality of LLRs, the LLR computation unit 213 may multiply the calculated values of the LLRs by the corresponding SNRs. Specifically, the LLR computation unit 2 may calculate an LLR further on the basis of the noise power or the signal-to-noise power ratio. In addition, in a case where LLRs of different QAM modulated signals are processed at the same time by the subsequent error correction decoding unit 1, the LLR computation unit 213 may divide each of the LLRs by $2(M-1)/3$, which is a square of a coefficient for correcting the signal scale described above. Specifically, the LLR computation unit 213 may correct the signal scale by dividing the LLR of the most significant bit calculated by using the multiplication coefficient and the additional value by $2(2^{2m}-1)/3$.

In addition, communication performed in the communication system of the present embodiment may be communication by wire or may radio communication. Furthermore, communication performed by the communication system of the present embodiment may be multicarrier communication, or may be single carrier communication. In addition, while an example of one transmission system and one reception system are presented in the communication system illustrated in FIG. 1, the number of signal systems may be more than one for both of transmission and reception without being limited to one. In particular, in a case where the communication performed in the communication system of the present embodiment is radio communication, spatial multiplexing transmission using a transmission system called multiple-input multiple-output (MIMO) including a plurality of antennae (input/output systems) may be performed.

As described above, the LLR calculation unit 2 of the present embodiment is capable of calculating an LLR for any modulo boundary value by simple processing of performing a range detection process, a coefficient determination process, and an LLR computation process on a received signal resulting from a modulo operation. Specifically, the LLR calculation unit 2 of the present embodiment is capable of calculating a log-likelihood ratio for any modulo boundary value with reduced amount of computation and hardware size.

The configurations presented in the embodiment above are examples of the present invention, and can be combined with other known technologies or can be partly omitted or modified without departing from the scope of the present invention.

Reference Signs List

1 error correction decoding unit; 2 LLR calculation unit; 3, 14 modulo operation unit; 4 detection unit; 10 transmission device; 101 error correction coding unit; 12 QAM modulation unit; 13 interference subtraction unit; 20 reception device; 30 transmission path; 21 LLR calculation unit for $b_0$; 22 LLR calculation unit for $b_1$; 23 LLR calculation unit for $b_2$; 211, 221 range detection unit; 212, 222 coefficient determination unit; 213, 223 LLR computation unit.

**Claims**

**1.** A log-likelihood ratio calculation circuit comprising:

a range detection unit to detect a range in which a received signal resulting from a modulo operation is present among a plurality of ranges defined on the basis of a boundary value in the modulo operation;

a coefficient determination unit to determine a coefficient to be used for calculation of a log-likelihood ratio for a most significant bit in quadrature amplitude modulation of the received signal resulting from the modulo operation on the basis of a result of detection by the range detection unit; and

a computation unit to calculate the log-likelihood ratio for the most significant bit by using the received signal resulting from the modulo operation and the determined coefficient.

**2.** The log-likelihood ratio calculation circuit according to claim 1, wherein
the coefficient includes a multiplication coefficient and an additional value, and
the computation unit calculates the log-likelihood ratio of the most significant bit by multiplying the received signal resulting from the modulo operation by the multiplication coefficient and adding the additional value to a result of multiplication.

**3.** The log-likelihood ratio calculation circuit according to claim 2, wherein
when m is an integer equal to or larger than 1, y represents the received signal resulting from the modulo operation, sign(y) represents a positive or negative sign of y, a boundary value in the modulo operation is represented by $\tau$, and n is an integer, the coefficient determination unit determines $\alpha_0(y)$ being the multiplication coefficient and $\beta_0(y)$ being the additional value for a most significant bit among one or more bits corresponding to signal points in quadrature amplitude modulation with a level of $2^{2m}$ according to the following formulae (1) to (4).
[Formula 1]

$$\text{when } |y| < \tau - 2^{m-1} \text{ and } 2n \le |y| < 2(n+1)\ \left(n = 0, \cdots, 2^{m-1} - 2\right),$$
$$\alpha_0(y) = 4(n+1),\ \beta_0(y) = -sign(y) \cdot 4(n+1)n$$

$$\ldots (1)$$

[Formula 2]

$$\text{when } |y| < \tau - 2^{m-1} \text{ and } 2^m - 2 \le |y|,$$
$$\alpha_0(y) = 2^{m+1},\ \beta_0(y) = -sign(y) \cdot 2^{m+1}(2^{m-1} - 1) \qquad \ldots (2)$$

[Formula 3]

$$\text{when } \tau - 2^{m-1} \le |y| \text{ and } 2n \le |y| < 2(n+1)\ \left(n = \left\lfloor \frac{\tau - 2^{m-1}}{2} \right\rfloor, \cdots, 2^{m-1} - 2\right),$$
$$\alpha_0(y) = 4(-\tau + n + 2^{m-1}),\ \beta_0(y) = -sign(y) \cdot 4(-\tau + n + 2^{m-1})(\tau + n - 2^{m-1} + 1)$$
$$\ldots (3)$$

[Formula 4]

$$\text{when } \tau - 2^{m-1} \le |y| \text{ and } 2^m - 2 \le |y|,$$
$$\alpha_0(y) = 4(-\tau + 2^m - 1),\ \beta_0(y) = -sign(y) \cdot 4\tau(-\tau + 2^m - 1) \qquad \ldots (4)$$

**4.** The log-likelihood ratio calculation circuit according to any one of claims 1 to 3, wherein
the computation unit calculates the log-likelihood ratio of the most significant bit further on the basis of noise power or a signal-to-noise power ratio.

**5.** The log-likelihood ratio calculation circuit according to claim 3, wherein the computation unit corrects a signal scale by dividing the log-likelihood ratio of the most significant bit calculated by using the coefficient by $2 \times (2^{2m}-1)/3$.

6. A reception device comprising the log-likelihood ratio calculation circuit according to any one of claims 1 to 5.

7. A method for calculating a log-likelihood ratio in a reception device to receive a signal subjected to quadrature amplitude modulation of a level $2^{2m}$ and a modulo operation and transmitted, m being an integer equal to or larger than 1, the method comprising:

calculating L(y) representing a log-likelihood ratio of a most significant bit in quadrature amplitude modulation of a level $2^{2m}$ according to the following formula (5) where y represents a received signal resulting from the modulo operation, sign(y) represents a positive or negative sign of y, a boundary value in the modulo operation is represented by $\tau$, and n is an integer.

[Formula 5]

$$L(y) = \begin{cases} 4(n+1)y - \text{sign}(y) \cdot 4(n+1)n & \left(|y| < \tau - 2^{m-1} \text{ and } 2n \le |y| < 2(n+1), n = 0, \cdots, 2^{m-1} - 2\right) \\ 2^{m+1}y - \text{sign}(y) \cdot 2^{m+1}(2^{m-1} - 1) & \left(|y| < \tau - 2^{m-1} \text{ and } 2^m - 2 \le |y|\right) \\ 4(-\tau + n + 2^{m-1})y - \text{sign}(y) \cdot 4(-\tau + n + 2^{m-1})(\tau + n - 2^{m-1} + 1) & \left(\tau - 2^{m-1} \le |y| \text{ and } 2n \le |y| < 2(n+1), n = \left\lfloor \frac{\tau - 2^{m-1}}{2} \right\rfloor, \cdots, 2^{m-1} - 2\right) \\ 4(-\tau + 2^m - 1)y - \text{sign}(y) \cdot 4\tau(-\tau + 2^m - 1) & \left(\tau - 2^{m-1} \le |y| \text{ and } 2^m - 2 \le |y|\right) \end{cases}$$

$\cdots$ (5)

# FIG.1

EP 3 432 496 A1

# FIG.2

# FIG.3

SIGNAL POINTS BEFORE
APPLICATION OF MODULO IN THP

# FIG.4

SIGNAL POINTS AFTER APPLICATION OF
MODULO IN THP ($\tau = 1.225$)

# FIG.5

| | -7 | -5 | -3 | -1 | +1 | +3 | +5 | +7 |
|---|---|---|---|---|---|---|---|---|
| $[b_0 \ b_1 \ b_2]=$ | [010] | [011] | [001] | [000] | [100] | [101] | [111] | [110] |

# FIG.6

| SUBJECT BIT | SIGN DETERMINATION | RANGE DETECTION | MULTIPLICATION COEFFICIENT $\alpha_i(y)$ | ADDITIONAL VALUE $\beta_i(y)$ |
|---|---|---|---|---|
| $b_0$ | $sign(y)$ | $|y|<2$ | +4 | 0 |
| | | $2 \leq |y| < 4$ | +8 | $-sign(y) \cdot 8$ |
| | | $4 \leq |y| < 6$ | +12 | $-sign(y) \cdot 24$ |
| | | $6 \leq |y|$ | +16 | $-sign(y) \cdot 48$ |
| $b_1$ | $sign(y)$ | $|y|<2$ | $-sign(y) \cdot 8$ | +24 |
| | | $2 \leq |y| < 6$ | $-sign(y) \cdot 4$ | +16 |
| | | $6 \leq |y|$ | $-sign(y) \cdot 8$ | +40 |
| $b_2$ | $sign(y)$ | $|y|<4$ | $sign(y) \cdot 4$ | -8 |
| | | $4 \leq |y|$ | $-sign(y) \cdot 4$ | +24 |

# FIG.7

EXTENDED
SIGNAL POINT
CANDIDATES

RECEIVED SIGNAL RESULTING
FROM MODULO

SIGNAL POINT
CANDIDATES
BEFORE MODULO

501

500

# FIG.8

LLR CALCULATION UNIT — 2

c0

d0

LLR CALCULATION UNIT FOR $b_0$ — 21 — d10

LLR CALCULATION UNIT FOR $b_1$ — 22 — d11

LLR CALCULATION UNIT FOR $b_2$ — 23 — d12

# FIG.9

LLR CALCULATION UNIT FOR $b_0$ — 21

c0

d0

RANGE DETECTION UNIT — 211

COEFFICIENT DETERMINA-TION UNIT — 212

LLR COMPUTA-TION UNIT — 213

d10

# FIG.10

LLR CALCULATION UNIT FOR $b_1$ — 22

d0

RANGE DETECTION UNIT — 221

COEFFICIENT DETERMINA-TION UNIT — 222

LLR COMPUTA-TION UNIT — 223

d11

# FIG.11

| | | | | | | | | | | | | |
|---|---|---|---|---|---|---|---|---|---|---|---|---|
| $-2\tau+5$ | $-2\tau+7$ | $-7$ | $-5$ | $-3$ | $-1$ | $+1$ | $+3$ | $+5$ | $+7$ | $2\tau-7$ | $2\tau-5$ |
| [111] | [110] | [010] | [011] | [001] | [000] | [100] | [101] | [111] | [110] | [010] | [011] |

MODULO REPEATED VIRTUAL REGION

MODULO REPEATED VIRTUAL REGION

$-\tau$     $\tau-4$     $+\tau$

# FIG.12

| SUBJECT BIT | SET VALUES IN RANGE DETECTION UNIT | | SET VALUES IN COEFFICIENT DETERMINATION UNIT | |
| --- | --- | --- | --- | --- |
| | SIGN DETERMINATION | RANGE DETECTION | MULTIPLICATION COEFFICIENT $\alpha_0(y)$ | ADDITIONAL VALUE $\beta_0(y)$ |
| $b_0$ | $sign(y)$ | (R1)$\|y\|<\tau-4$ AND $\|y\|<2$ | $+4$ | $0$ |
| | | (R2)$\|y\|<\tau-4$ AND $2\leq\|y\|<4$ | $+8$ | $-sign(y)\cdot 8$ |
| | | (R3)$\|y\|<\tau-4$ AND $4\leq\|y\|<6$ | $+12$ | $-sign(y)\cdot 24$ |
| | | (R4)$\|y\|<\tau-4$ AND $6\leq\|y\|$ | $+16$ | $-sign(y)\cdot 48$ |
| | | (R5) $\tau-4\leq\|y\|$ AND $2\leq\|y\|<4$ | $+4(-\tau+5)$ | $-sign(y)\cdot 4(-\tau+5)(\tau-2)$ |
| | | (R6) $\tau-4\leq\|y\|$ AND $4\leq\|y\|<6$ | $+4(-\tau+6)$ | $-sign(y)\cdot 4(-\tau+6)(\tau-1)$ |
| | | (R7) $\tau-4\leq\|y\|$ AND $6\leq\|y\|$ | $+4(-\tau+7)$ | $-sign(y)\cdot 4\tau(-\tau+7)$ |

# FIG.13

300 PROCESSING CIRCUIT

# FIG.14

400

401 PROCESSOR

402 MEMORY

**INTERNATIONAL SEARCH REPORT**

| | International application No. |
|---|---|
| | PCT/JP2016/058156 |

**A. CLASSIFICATION OF SUBJECT MATTER**
*H04J99/00*(2009.01)i, *H03M13/45*(2006.01)i, *H04B7/04*(2006.01)i, *H04L27/38*(2006.01)i

According to International Patent Classification (IPC) or to both national classification and IPC

**B. FIELDS SEARCHED**

Minimum documentation searched (classification system followed by classification symbols)
H04J99/00, H03M13/45, H04B7/04, H04L27/38

Documentation searched other than minimum documentation to the extent that such documents are included in the fields searched
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)
IEEE Xplore, CiNii

**C. DOCUMENTS CONSIDERED TO BE RELEVANT**

| Category* | Citation of document, with indication, where appropriate, of the relevant passages | Relevant to claim No. |
|---|---|---|
| X<br>A | Shigenori Kinjo, A low complexity soft demapping method for expanded M-QAM constellations, Circuits and Systems (APCCAS), 2014 IEEE Asia Pacific Conference on, IEEE, 2014.11.20, pp.137-140 | 1-2,4,6<br>3,5,7 |
| A | Yasuhiko TANABE et al., "An Error Reduction Method of Modulo Operation for a MIMO Broadcast Channel Using Tomlinson-Harashima Precoding in Low SNR Region", 2008 Nen IEICE Communications Society Conference Koen Ronbunshu 1, 02 September 2008 (02.09.2008), pages "S-1" to "S-2" | 1-7 |

| ☒ | Further documents are listed in the continuation of Box C. | ☐ | See patent family annex. |
|---|---|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 13 April 2016 (13.04.16) | 26 April 2016 (26.04.16) |

| Name and mailing address of the ISA/<br>Japan Patent Office<br>3-4-3,Kasumigaseki,Chiyoda-ku,<br>Tokyo 100-8915,Japan | Authorized officer<br><br><br>Telephone No. |
|---|---|

Form PCT/ISA/210 (second sheet) (January 2015)

**INTERNATIONAL SEARCH REPORT**

International application No.

PCT/JP2016/058156

C (Continuation). DOCUMENTS CONSIDERED TO BE RELEVANT

| Category* | Citation of document, with indication, where appropriate, of the relevant passages | Relevant to claim No. |
|---|---|---|
| A | Akinori OHASHI et al., "A Study on Low-Complexity Calculation of Log Likelihood Ratio for Quardrature Amplitude Modulation", 2013 Nen IEICE Communications Society Conference Tsushin Koen Ronbunshu 1, IEICE, 20 September 2013 (20.09.2013), page 368 | 1-7 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MAX H. M. COSTA.** Writing on Dirty Paper. *IEEE TRANSACTIONS ON INFORMATION THEORY,* May 1983, vol. IT-29 (3), 439-441
- **M. TOMLINSON.** NEW AUTOMATIC EQUALISER EMPLOYING MODULO ARITHMETIC. *ELECTRONICS LETTERS,* March 1971, vol. 7, 138-139
- **H. HARASHIMA ; H. MIYAKAWA.** Matched-Transmission Technique for Channels With Intersymbol Interference. *IEEE TRANSACTIONS ON COMMUNICATIONS,* August 1972, vol. COM-20 (4), 774-779
- **H. MATSUOKA ; S. SAMPEI ; N. MORINAGA ; Y. KAMIO.** Adaptive Modulation System with Punctured Convolutional Code for High Quality Personal Communication Systems. *IEICE TRANS. COMMUN.,* March 1996, vol. E79-B (3), 328-334
- **R. PYNDIAH ; A. PICART ; A. GLAVIEUX.** PERFORMANCE OF BLOCK TURBO CODED 16-QAM AND 64-QAM MODULATIONS. *Proc. Globecom'95,* November 1995, vol. 2, 1039-1043
- **E.C.Y. PEH ; Y.-C. LIANG.** Power and Modulo Loss Tradeoff with Expanded Soft Demapper for LDPC Coded GMD-THP MIMO Systems. *IEEE TRANSACTIONS ON WIRELESS COMMUNICATIONS,* February 2009, vol. 8 (2), 714-724
- **S. KINJO.** An efficient soft demapper for Tomlinson-Harashima precoded systems. *IEICE Communications Express,* March 2015, vol. 4 (3), 89-94